# EUROPEAN PATENT APPLICATION

(11) **EP 4 447 621 A1**
(43) Date of publication of application: **16.10.2024**
(21) Application number: 24168318.4
(22) Date of filing: 03.04.2024
(51) Int. Cl.: H05K 1/02, H05K 3/34

(54) **CONFIGURABLE WARPAGE CONTROL SPACERS**

(30) Priority: 11.04.2023 US 202318298645
(71) Applicant: Nokia Solutions and Networks Oy, 02610 Espoo (FI)
(72) Inventor: Chan, Alex, Ottawa, K2J5X9 (CA); Brown, Paul, Wakefield, J0X 3G0 (CA); Fazari, Daniel, Carleton Place, K7C3W7 (CA)
(74) Representative: Swindell & Pearson Limited

(57) **Abstract**

A circuit assembly, including: an integrated circuit (IC) with a plurality of connection pads; a ball grid array (BGA) including a plurality of solder balls arranged in an array, where plurality of solder balls are configured to connect the plurality of connections pads to a plurality of connections pads on a PCB; and a BGA spacer configured to fit among the plurality of solder balls, wherein the BGA spacer has a width based upon a height and spacing of the plurality of solder balls and a height based upon a height and spacing of the plurality of solder balls and a minimum distance between the IC and the PCB to prevent shorting of adjacent solder balls.

## Description

### FIELD OF THE DISCLOSURE

Various exemplary embodiments disclosed herein relate to configurable warpage control spacers for use in ball grid array mounted integrated circuits.

### BACKGROUND

A ball grid array (BGA) is a type of surface-mount packaging (a chip carrier) used for integrated circuits (IC). BGA packages are used to permanently mount devices such as microprocessors. A BGA may provide more interconnection pins than can be put on a dual in-line or flat package. The whole bottom surface of the device may be used, instead of just the perimeter. The traces connecting the package's leads to the wires or solder balls which connect the die to package are also on average shorter than with a perimeter-only type, leading to better performance at high speeds.

### SUMMARY

A summary of various exemplary embodiments is presented below.

Various embodiments relate to a circuit assembly, including: an integrated circuit (IC) with a plurality of connection pads; a ball grid array (BGA) including a plurality of solder balls arranged in an array, wherein the plurality of solder balls are configured to connect the plurality of connections pads to a plurality of connections pads on a PCB; and a BGA spacer configured to fit among the plurality of solder balls, wherein the BGA spacer has a width based upon a height and spacing of the plurality of solder balls and a height based upon a height and spacing of the plurality of solder balls and a minimum distance between the IC and the PCB to prevent shorting of adjacent solder balls.

Various embodiments are described, further including a plurality of additional BGA spacers configured to fit among the plurality of solder balls, wherein the additional BGA spacers have a height and width based upon a height and spacing of the plurality of solder balls.

Various embodiments are described, wherein the BGA spacer and one of the plurality of BGA spacers have a different shape.

Various embodiments are described, wherein the BGA spacer is located among the plurality of solder balls at a location where the distance between the IC and the BGA is less than a minimum distance between the IC and the PCB to prevent shorting of adjacent solder balls due to warpage of the IC.

Various embodiments are described, wherein the BGA spacers are interstitial type BGA spacers.

Various embodiments are described, wherein the BGA spacers are one of a bar spacer, L-spacer, T-spacer, cross spacer, and X-spacer.

Various embodiments are described, wherein the BGA spacers are enclosure type BGA spacers.

Various embodiments are described, wherein the BGA spacers are one of a square spacer, rectangle spacer, triangle spacer, diamond spacer, and polygon spacer.

Further various embodiments relate to a method of assembling a circuit assembly, including: characterizing warpage characteristics of an integrated circuit (IC) with a plurality of connect ion pads; determining a location of a ball grid array (BGA) spacer among a plurality of solder balls that are part of a BGA attached to the IC based upon the warpage characteristics of the IC; determining a shape and dimensions of the BGA spacer based upon a height and spacing of the plurality of solder balls, wherein the height of the BGA spacer is further based upon a minimum distance between the IC and a PCB to prevent shorting of adjacent solder balls; producing the BGA spacer; placing the BGA spacer on the BGA among the plurality of solder balls; placing BGA and IC on the PCB wherein the PCB has a plurality of connection pads corresponding to the plurality of solder balls; and performing solder processing of the IC, BGA, and PCB.

Various embodiments are described, wherein determining the location of the BGA spacer includes identifying a location where a distance between the IC and the PCB is less than a minimum distance between the IC and the PCB to prevent shorting of adjacent solder balls.

Various embodiments are described, further including characterizing warpage characteristics of the PCB, wherein determining the location of the BGA spacer is further based on the warpage characteristics of the PCB.

Various embodiments are described, further including producing a custom installation template, wherein placing the BGA spacer on the BGA includes using the custom install template.

Further various embodiments relate to a method of assembling a circuit assembly, including: characterizing warpage characteristics of an integrated circuit (IC) with a plurality of connection pads; determining locations of a plurality of ball grid array (BGA) spacers among a plurality of solder balls that are part of a BGA attached to the IC based upon the warpage characteristics of the IC; determining a shape and dimensions of the plurality of BGA spacers based upon a height and spacing of the plurality of solder balls, wherein a height of the plurality of BGA spacers is further based upon a minimum distance between the IC and a PCB to prevent shorting of adjacent solder balls; producing the plurality of BGA spacers; placing the plurality of BGA spacers on the BGA among the plurality of solder balls; placing the BGA and IC on the PCB wherein the PCB has a plurality of connection pads corresponding to the plurality of solder balls; and perform solder processing of the IC, BGA, and PCB.

Various embodiments are described, wherein determining the location of the plurality of BGA spacers includes identifying a location where a distance between the IC and the PCB are less than a minimum distance between the IC and the PCB to prevent shorting of adjacent solder balls.

Various embodiments are described, further including characterizing warpage characteristics of the PCB, wherein determining the location of the plurality of BGA spacers is further based on the warpage characteristics of the PCB.

Various embodiments are described, further including producing a custom installation template, wherein placing the plurality of BGA spacers on the BGA includes using the custom installation template.

The foregoing has outlined rather broadly the features and technical advantages of examples according to the disclosure in order that the detailed description that follows may be better understood. Additional features and advantages will be described hereinafter. The conception and specific examples disclosed may be readily utilized as a basis for modifying or designing other structures for carrying out the same purposes of the present disclosure. Such equivalent constructions do not depart from the scope of the appended claims. Characteristics of the concepts disclosed herein, both their organization and method of operation, together with associated advantages will be better understood from the following description when considered in connection with the accompanying figures. Each of the figures is provided for the purposes of illustration and description, and not as a definition of the limits of the claims.

### BRIEF DESCRIPTION OF DRAWINGS

So that the above-recited features of the present disclosure can be understood in detail, a more particular description, briefly summarized above, may be had by reference to aspects, some of which are illustrated in the appended drawings. It is to be noted, however, that the appended drawings illustrate only certain typical aspects of this disclosure and are therefore not to be considered limiting of its scope, for the description may admit to other equally effective aspects. The same reference numbers in different drawings may identify the same or similar elements.
FIG. 1 illustrates the use of a BGA where adjacent solder balls become connected.
FIGs. 2A and 2B illustrate two different examples of warping of an IC.
FIG. 3A illustrates a 3D plot showing the warping of an IC at 23°C.
FIG. 3B shows a plot of displacement along the two diagonals of the IC at 23°C.
FIG. 4A illustrates a 3D plot showing the warping of an IC at 180°C.
FIG. 4B shows a plot of displacement along the two diagonals of the IC at 180°C.
FIG. 5A illlustrates a 3D plot showing the warping of an IC at 225°C.
FIG. 5B shows a plot of displacement along the two diagonals of the IC at 225°C.
FIG. 6 illustrates a BGA having a square arrangement of the solder balls with a variety of different BGA spacers.
FIG. 7 illustrates a BGA having an offset arrangement of the solder balls with a variety of different BGA spacers.
FIGs. 8A-F illustrate front perspective, back perspective, front, back, bottom perspective, and cross-sectional views of an embodiment of an installation template .
FIG. 9 illustrates a flow chart of the method IC placement method.

### DETAILED DESCRIPTION

Various aspects of the disclosure are described more fully hereinafter with reference to the accompanying drawings. This disclosure may, however, be embodied in many different forms and should not be construed as limited to any specific structure or function presented throughout this disclosure. Rather, these aspects are provided so that this disclosure will be thorough and complete, and will fully convey the scope of the disclosure to those skilled in the art. Based on the teachings herein one skilled in the art should appreciate that the scope of the disclosure is intended to cover any aspect of the disclosure disclosed herein, whether implemented independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure disclosed herein may be embodied by one or more elements of a claim.

Several aspects of BGA systems will now be presented with reference to various apparatuses and techniques. These apparatuses and techniques will be described in the following detailed description and illustrated in the accompanying drawings by various blocks, modules, components, circuits, steps, processes, algorithms, and/or the like (collectively referred to as "elements"). These elements may be implemented using hardware, software, or combinations thereof. Whether such elements are implemented as hardware or software depends upon the particular application and design constraints imposed on the overall system.

As ICs and hence BGAs become larger, warpage of the IC and BGA is becoming more difficult or impossible to control. As a result, soldering large ICs with BGAs on a Printed Circuit Board (PCB) is becoming more problematic. Depending on the shape of the warpage, the resulting interaction with the underlying PCB may result in over compression of some of the solder balls, leading to solder shorts, and/or it may also lead to solder openings where the connection between the IC is not properly connected to the PCB. Embodiments of a BGA spacer will be described in order to eliminate this issue for large BGAs and smaller problematic BGAs.

BGA warpage is the result of a mismatch in the constituent material properties of the IC and because these materials are (and must be) fundamentally different, there are limits on how much warpage may be controlled at the design phase of the IC. As a result, the true behavior of the IC and the magnitude of the warpage are generally not known until after the IC has been physically produced. At this late stage, many other key factors: (IC and substrate routing, pin assignment, signal integrity (SI)and power considerations) make changes to the IC structure or pin out, problematic and costly. Barring the case of completely unacceptable warpage (i.e. un-manufacturable), the IC vendor is unlikely to make major changes to the IC structure or pin out to mitigate warpage at this stage. To mitigate package warpage without a fundamental redesign of the IC requires detailed knowledge of how it will warp so that localized changes can be made to accommodate spacers. However because this warpage behavior is not known until after the chip is produced and unlikely to be revisited (as described above) warpage remains a constant problem undercutting assembly yield and product reliability. As a result, BGAs, especially large BGAs with significant warpage, more frequently have defects such as solder shorts or opens. Also, there are chips with more complex warpage modes (e.g., "w" shaped warp, saddle back shaped warp...) and accommodating these other potential warpage modes proactively would mean depopulating too many sites on the chip and therefore simply becomes unfeasible.

Custom BGA spacers may be used to reduce BGA soldering defects. The problem of thermal BGA warpage resulting in solder defects may be solved by characterizing BGA thermal warpage and then placing BGA spacers interleaved among the BGA solder balls. In previous attempts to resolve this issue, the approach sought to change how the PCB or the BGA package are designed. In both cases this requires forward thinking and accurate prediction of the anticipated chip warpage behavior, which simply does not exist currently. The use of BGA spacers means that no BGA pads/balls in the BGA will need to be removed or displaced to address the issue of warpage. This is especially true where the BGA is fully populated.

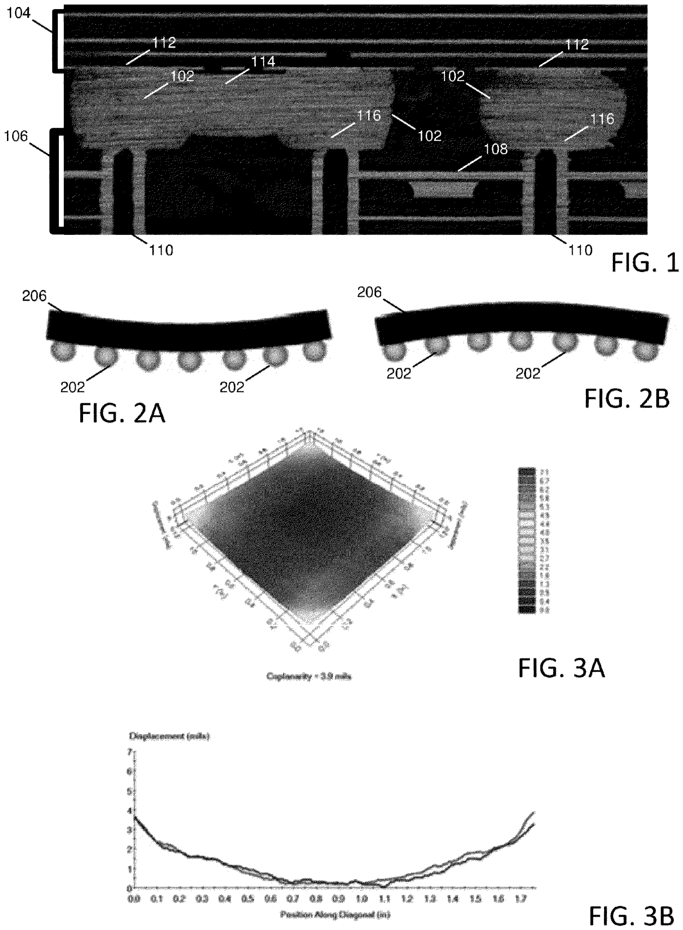

FIG. 1 illustrates the use of a BGA where adjacent solder balls become connected. In FIG. 1, the IC 104 has a BGA attached that includes a plurality of solder balls 102. The solder balls 102 connect to the IC 104 via IC pad 112. The solder balls 102 also contact PCB pads 116 on PCB 106. The PCB 106 may also include copper layer 108 and through holes 110. As can be seen in FIG. 1, two of the solder balls 102 have melted together to form solder short 114. The solder short 114 causes a short between the adjacent IC pads 112 and PCB pads 116. This will cause the PCB 106 to be rejected or the connection of the IC 104 to the PCB 106 needs to be reworked, which is expensive and time consuming.

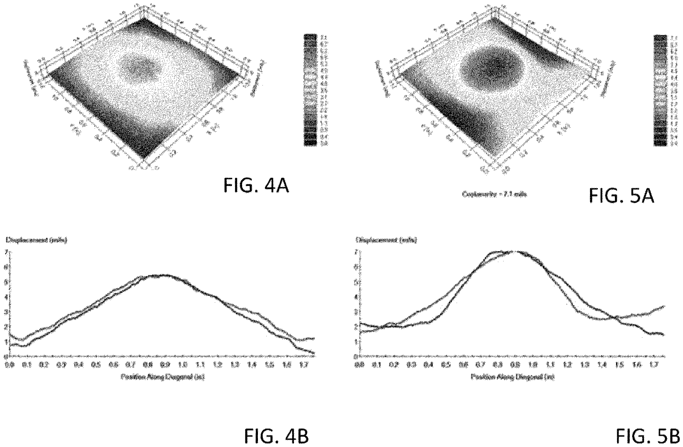

FIGs. 2A and 2B illustrate two different examples of warping of an IC 206. In FIG. 2A, the IC 206 has the outer edges warped upward and the center downward. In FIG 2B, the IC 206 has the center portion of the IC is warped upward and the outer edges downward. As can be seen in both cases this causes the solder balls 202 to follow the contour of the warped IC 206 which means that there may be connection issues with the PCB. FIG. 3A illustrates a 3D plot showing the warping of an IC at 23°C. FIG. 3B shows a plot of displacement along the two diagonals of the IC at 23°C. This example is like the example in FIG. 2A. FIG. 4A illustrates a 3D plot showing the warping of an IC at 180°C. FIG. 4B shows a plot of displacement along the two diagonals of the IC at 180°C. FIG. 5A illustrates a 3D plot showing the warping of an IC at 225°C. FIG. 5B shows a plot of displacement along the two diagonals of the IC at 225°C. FIGs. 4A and 4B and FIGs. 5A and 5B are like the example in FIG. 2B. The plots illustrated in FIGs. 3A-5B may be made for any IC of interest. They show the warping behavior of the IC at different temperatures, and this behavior may be used to place BGA spacers among the solder balls of the BGA between the IC and the PCB.

During manufacture of the PCB assembly (PCBA), an IC with a BGA will be placed on a portion of the PCB with a pad structure pattern matching a pad structure pattern on the IC and the BGA. Various tools are used to align the IC with the correct pad structure pattern on the IC. Solder paste may be placed on the PCB pads to facilitate soldering with the solder balls of the BGA. Heat may then be applied to the BGA to melt the solder balls to form connections between the IC and the PCB. The solder balls then cool to form a solid connection between pads on the IC and pads on the PCB. After cooling, the distance between the IC and the PCB will typically be less than the height of the solder balls because the solder balls spread out some when they melt. Further, there is going to be a minimum distance between the IC and the PCB where adjacent solder balls will not run together and short. When the distance between the IC and PCB falls below this minimum distance the likelihood of adjacent balls shorting increases as the material of the solder balls spreads over a greater area because of the reduced distance between the IC and BGA. It is noted that when the PCB and the IC are each flat, then the distance between the IC and the PCB is constant across the BGA. But when the IC warps as described above, then there is a danger that the distance between the IC and the PCB may drop below the minimum distance and this will increase the likelihood of shorts.

Therefore, the height of BGA spacers may be selected based upon a minimum distance between the IC and the PCB where solder balls will not flow into adjacent solder balls. This will prevent or greatly reduce the likelihood of shorts due to warpage of the IC.

It is noted that in addition to the IC warping, the PCB may warp as well. So this warpage needed to be characterized so that the combined effect of warpage of the IC and PCB may be used to determine the placement of spacers.

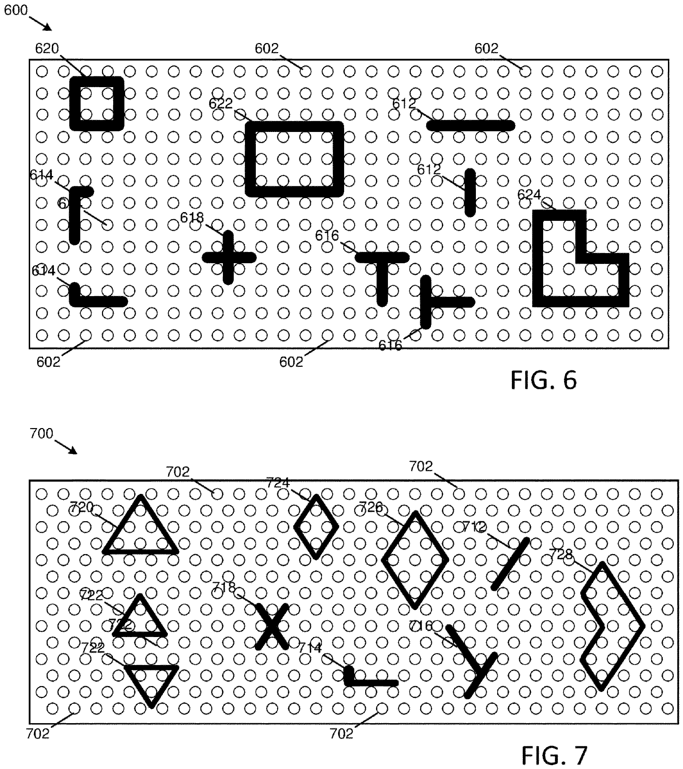

FIG. 6 illustrates a BGA having a square arrangement of the solder balls with a variety of different BGA spacers. FIG. 7 illustrates a BGA having an offset arrangement of the solder balls with a variety of different BGA spacers. In FIG. 6, the IC 600 includes a BGA having a plurality of solder balls 602. Various BGA spacers are shown as being placed among the solder balls 602 including bar spacer 612, L-spacer 614, T-spacer 616, cross spacer 618, square spacer 620, rectangle spacer 622, and polygon spacer 624. The bar spacer 612 is simply in a line shape that has a width sized to fit between the solder balls 602. The length of the bar spacer 612 may be any length and may be chosen to prevent shorting between specific solder balls 602. Further the bar spacer 612 may be oriented in any direction that will fit within the pattern of the BGA. The width of all of the BGA spacers may be selected so that they may be placed snugly among the solder balls 602 so that the BGA spacers will remain in place. Accordingly, the specific width of any BGA spacer may be selected based upon spacing of the BGA and the size of the solder balls 602.

The L-spacer 614 is shown as having two legs. In the specific example shown, one leg is longer than the other, but either leg may be any length. Further, the L-spacer 614 may have any orientation that will fit within the pattern of the BGA. The T-spacer 616 has two legs that form a T shape. The legs may be any length, and the T-spacer 616 may have any orientation that will fit within the pattern of the BGA. The cross spacer 618 includes two linear portions that cross, and the linear portions may have any length. The bar spacer 612, L-spacer 614, T-spacer 616, and cross spacer 618 are interstitial spacers designed to separate sets of solder balls 602 from one another and to provide a minimum spacing between the IC and the PCB.

The square spacer 620, rectangle spacer 622, and polygon spacer 624 are enclosure style spacers that enclose a set of solder balls 602. One possible application for the enclosure style BGA spacers is to enclose a set of solder balls 602 that are all connected to the same line, e.g., a ground or a power line. In this case if any of the enclosed solder balls 602 do spread and connect to adjacent solder balls 602 there is no short as they are both connected to the same line. The square spacer 620 has a square shape that encloses four solder balls 602 in this example. The square spacer 620 may be smaller or larger to enclose fewer or more solder balls 602. The rectangle spacer 622 has a rectangular shape that encloses 12 solder balls 602, but the rectangle spacer 622 may be smaller or larger to enclose fewer or more solder balls 602. The polygon spacer 624 illustrates that the BGA spacer can take on any polygonal shape. So any desired shape may be implemented by the BGA spacer.

In FIG. 7, adjacent rows of the BGA are offset from one another. Such spacing may be used to increase the density of the solder balls 702 in the BGA on the IC 700. Because the solder balls 702 are spaced differently from the solder balls 602 of FIG. 6 the BGA spacers may take similar but different shapes. The BGA spaces include bar spacer 712, L-spacer 714, T-spacer 716, X-spacer 718, large triangle spacer 720, small triangle spacer 722, small diamond spacer 724, large diamond spacer 726, and polygon spacer 728. The bar spacer 712 is like the bar spacer 612. The L-spacer 714 is like the L-spacer 614, but in the L-spacer 714 the legs may have different widths to accommodate the different spacing in the solder balls 702 in different directions. The T-spacer 716 is like the T-spacer 616 but its legs may not be substantially perpendicular to one another. The X-spacer 718 is similar to the cross spacer 618, but again the legs may not be substantially perpendicular to one another.

In FIG. 7, various enclosure type BGA spacers are shown including large triangle spacer 720, small triangle spacer 722, small diamond spacer 724, large diamond spacer 726, and polygon spacer 728. The large triangle spacer 720 and small triangle spacer 722 are triangle shaped spacers that may be any size to encompass a desired set of solder balls 702. Likewise, small diamond spacer 724 and large diamond spacer 726 are diamond shaped that may be any size to encompass a desired set of solder balls 702. The polygon spacer 728 shows how the BGA spacers may have any shape needed.

The BGA spacers may be formed in any manner and shape. The BGA spacers may be made of any non-conductive material such as plastic, dielectric material, ceramic, etc. The material selected will need to withstand reflow temperatures used during the manufacture of the circuit assembly. Other materials such as ceramic and metal can also be considered for manufacturing. The BGA spacers may be customized to the specific needs of a user and the specific IC and PCB. This may be accomplished using 3D printing to print the customized BGA spacers having a specific shape and dimensions. The BGA spacers may be made of a conductive material if the BGA spacer will only contact solder balls that are connected to the same line.

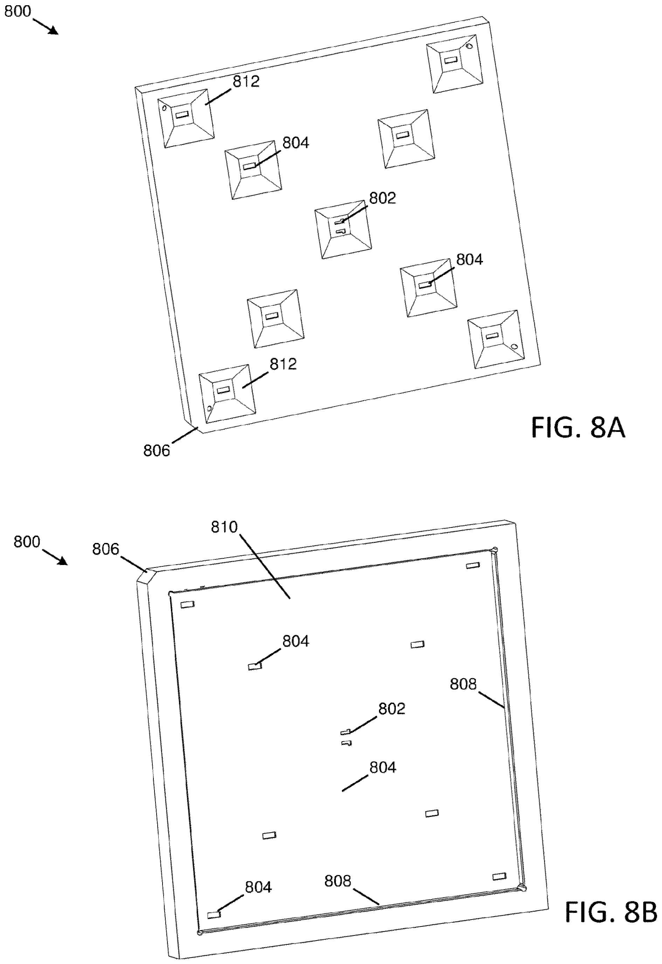

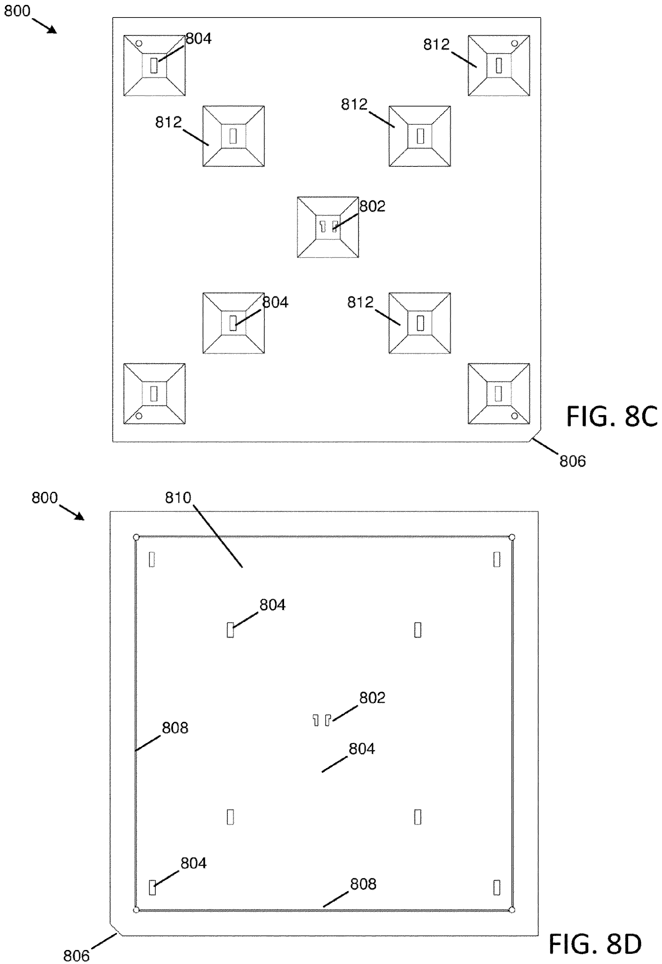

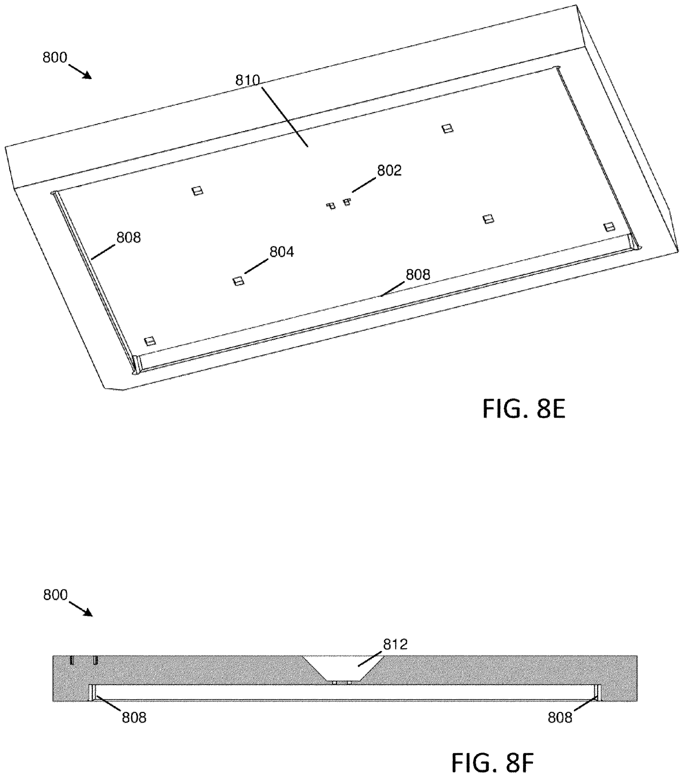

Because the dimensions of the BGA have become very small, that means that the BGA spacers will be very small. In order to facilitate the placement of the BGA spacers on the BGA an installation template 800 may be used. FIGs. 8A-F illustrate front perspective, back perspective, front, back, bottom perspective, and cross-sectional views of an embodiment of an installation template 800. In this example, the installation template 800 has a generally square shape that matches the IC associated with the installation template 800. If the IC has a different shape, the general shape of the installation template 800 may be complementary to the shape of the IC. The installation template 800 may have a plurality of template indents 812 each with a first spacer opening 802 or second spacer opening 804 at the bottom of the template indent 812. The first spacer opening 802 is L-shaped and may accommodate the placement of L-spacer 614 or L-spacer 714. The second spacer opening 804 is bar shaped and may accommodate the placement of bar spacer 612 or bar spacer 712. Other spacer openings with different shapes may be used as well the correspond to the shape of the spacers to be placed on the BGA. On one side of the installation template 800 there is a template inner surface 810 and guide surface 808 that forms a cavity that conforms with the BGA/IC assembly. The contour of the guide surface 808 may match the contour of the IC to allow for the installation template 800 to be placed over the BGA/IC assembly and to precisely locate the first spacer opening 802 and second spacer opening 804 relative to the BGA. The installation template 800 may also include an alignment notch 806 that helps to correctly orient the installation template 800 relative to the BGA/IC assembly.

During manufacture, the installation template 800 may be placed over the BGA/IC assembly. This results in the first spacer openings 802 and second spacer openings 804 being aligned with precise desired locations in the BGA. Then bar spacers 612 may be placed through second spacer opening 804 and onto the BGA. This may be accomplished by pushing the spacer through the second spacer opening 804 using a push tool. Likewise, L-spacers 614 may be placed through the first spacer opening 802 and onto the BGA.

It is noted that the example installation template 800 may take many different forms. The installation template 800 will be sized and shaped according to specific associated BGA/IC assembly. Further the number, location, shape, and size of the spacer openings will be based upon the BGA grid spacing, the BGA ball size, the warpage characteristics of the IC, and in some embodiments the warpage characteristics of the PCB. Therefore, the installation template 800 may be custom made for each IC to be placed on the PCB. This may be made using 3D printing. The installation template 800 may be made of any material.

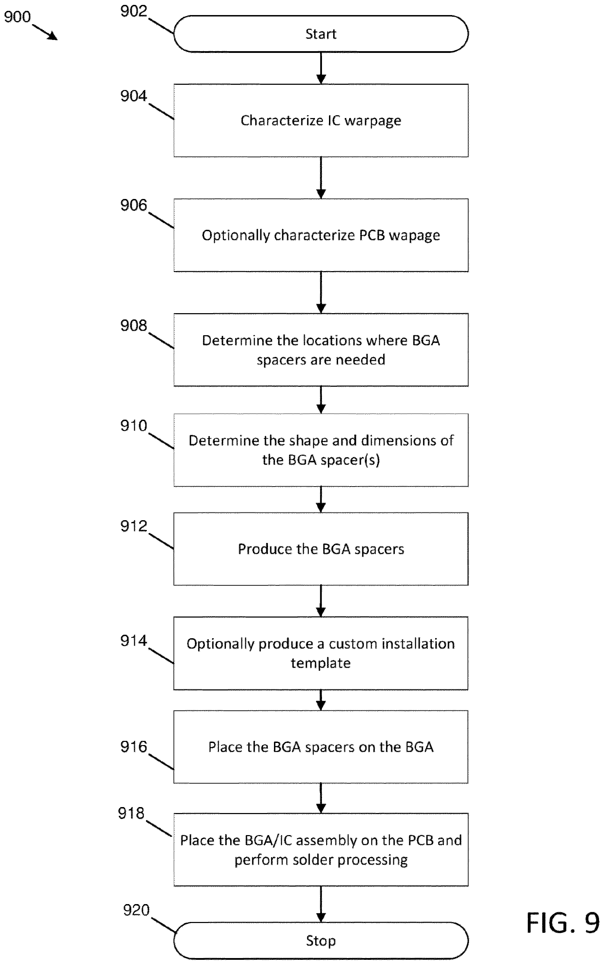

A method 900 of how the BGA spacers may be deployed in the placement of ICs on PCBs during manufacturing will now be described. FIG. 9 illustrates a flow chart of the method IC placement method. The method 900 starts at 902 and then characterizes the IC warpage 904. This characterization may be done using various known methods and at different temperatures related to the processing of the IC. The characterization may include producing plots like those in FIGs. 3A-5B. Next, the method 900 may optionally characterize the PCB warpage 906. This step may be carried out when the PCB exhibits warping. If the PCB does not significantly warp then this step may be skipped. The method 900 then determines the locations where the BGA spacers are needed 908. This determination may be carried out by determining how the distance between the IC and the PCB will vary based upon warpage. As discussed above there is a minimum distance between the IC and PCB that will ensure that adjacent solder balls will not short. This minimum distance is based upon the size of the BGA ball being used and the spacing of the BGA grid. The distance between the IC and the PCB when the IC warps will be determined at points across the BGA. Any locations that have a distance between the IC and the PCB less than the minimum distance may be identified as locations for a spacer. Further, various methods may be used to determine spacer placement based upon the general shape of the warpage of the IC. For example, when the center of the IC warps upward as in FIGs. 2B, 4A-B, and 5A, BGA spacers may be placed in the corners or along the edges of the BGA. In another example, when the center of the IC warps downward as in FIGs. 2A and 3A-B, BGA spacers may be placed near the peak of the downward warpage. If the PCB warpage is characterized and illustrates significant warpage of the PCB, This may be used to determine locations along the BGA where the distance between the IC and the PCB are less than the minimum distance. This may be done by determining the distance between the IC and PCB at a grid of points over the BGA using the warpage characteristics of the IC and the PCB.

Once the locations of the BGA spacers have been determined, the shape and dimensions of the BGA spacer(s) are determined 910. The shape may be selected based upon the shape and size of the characterized warpage areas where problems may arise. Also, if a group of solder balls in the BGA are connected to the same line, then an enclosure type of BGA spacer may be selected for use. Further, the shape of the BGA spacer may be affected by the specific grid layout of the BGA (e.g., square, rectangular, offset, etc.) Further, the dimensions of the BGA spacer will be determined based upon the BGA grid spacing and the size of the solder balls. Next, the method 900 will produce the specified BGA spacers 912. This may be done using any method, but 3D printing provides a reliable method of producing the custom BGA spacers. Next, the method 900 may optionally produce a custom installation template 914. As discussed above the installation template may be manufactured using various methods including 3D printing. Next, the method 900 will place the BGA spacers on the BGA 916. This may be done using the installation template or using other manual or automated methods of placing the spacers. Then the BGA/IC assembly is placed on the PCB and solder processing is performed 918. The method 900 then ends at 920.

In an alternative embodiment, BGA spacers may be placed in a fixed pattern across the BGA in order to account for any warpage of the IC and/or the PCB to ensure a minimum distance between the IC and the PCB across the BGA. This approach may be used with or without the characterization of the IC and/or PCB warpage.

The foregoing disclosure provides illustration and description but is not intended to be exhaustive or to limit the aspects to the precise form disclosed. Modifications and variations may be made in light of the above disclosure or may be acquired from practice of the aspects.

As used herein, the term "component" is intended to be broadly construed as hardware, firmware, and/or a combination of hardware and software. As used herein, a processor is implemented in hardware, firmware, and/or a combination of hardware and software.

As used herein, satisfying a threshold may, depending on the context, refer to a value being greater than the threshold, greater than or equal to the threshold, less than the threshold, less than or equal to the threshold, equal to the threshold, not equal to the threshold, and/or the like. It will be apparent that systems and/or methods described herein may be implemented in different forms of hardware, firmware, and/or a combination of hardware and software. The actual specialized control hardware or software code used to implement these systems and/or methods is not limiting of the aspects. Thus, the operation and behavior of the systems and/or methods were described herein without reference to specific software code-it being understood that software and hardware can be designed to implement the systems and/or methods based, at least in part, on the description herein.

As used herein, the term "non-transitory machine-readable storage medium" will be understood to exclude a transitory propagation signal but to include all forms of volatile and nonvolatile memory. When software is implemented on a processor, the combination of software and processor becomes a specific dedicated machine.

Because the data processing implementing the embodiments described herein is, for the most part, composed of electronic components and circuits known to those skilled in the art, circuit details will not be explained in any greater extent than that considered necessary as illustrated above, for the understanding and appreciation of the underlying concepts of the aspects described herein and in order not to obfuscate or distract from the teachings of the aspects described herein.

Unless stated otherwise, terms such as "first" and "second" are used to arbitrarily distinguish between the elements such terms describe. Thus, these terms are not necessarily intended to indicate temporal or other prioritization of such elements.

It should be appreciated by those skilled in the art that any block diagrams herein represent conceptual views of illustrative hardware embodying the principles of the aspects.

While each of the embodiments are described above in terms of their structural arrangements, it should be appreciated that the aspects also cover the associated methods of using the embodiments described above.

Even though particular combinations of features are recited in the claims and/or disclosed in the specification, these combinations are not intended to limit the disclosure of various aspects. In fact, many of these features may be combined in ways not specifically recited in the claims and/or disclosed in the specification. Although each dependent claim listed below may directly depend on only one claim, the disclosure of various aspects includes each dependent claim in combination with every other claim in the claim set. A phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

No element, act, or instruction used herein should be construed as critical or essential unless explicitly described as such. Also, as used herein, the articles "a" and "an" are intended to include one or more items, and may be used interchangeably with "one or more." Furthermore, as used herein, the terms "set" and "group" are intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," and/or the like are intended to be open-ended terms. Further, the phrase "based on" is intended to mean "based, at least in part, on" unless explicitly stated otherwise.

## Claims

1. A circuit assembly, comprising:
an integrated circuit (IC) with a plurality of connection pads;
a ball grid array (BGA) including a plurality of solder balls arranged in an array, wherein the plurality of solder balls are configured to connect the plurality of connections pads to a plurality of connections pads on a PCB; and
a BGA spacer configured to fit among the plurality of solder balls, wherein the BGA spacer has a width based upon a height and spacing of the plurality of solder balls and a height based upon a height and spacing of the plurality of solder balls and a minimum distance between the IC and the PCB to prevent shorting of adjacent solder balls.

2. The circuit assembly of claim 1, further comprising
a plurality of additional BGA spacers configured to fit among the plurality of solder balls, wherein the additional BGA spacers have a height and width based upon a height and spacing of the plurality of solder balls.

3. The circuit assembly of claim 2,
wherein the BGA spacer and one of the plurality of BGA spacers have a different shape.

4. The circuit assembly of claim 1,
wherein the BGA spacer is located among the plurality of solder balls at a location where the distance between the IC and the BGA is less than a minimum distance between the IC and the PCB to prevent shorting of adjacent solder balls due to warpage of the IC.

5. The circuit assembly of claim 1,
wherein the BGA spacers are at least one of interstitial type BGA spacers, and enclosure type BGA spacers.

6. The circuit assembly of claim 1,
wherein the BGA spacers are one of a bar spacer, L-spacer, T-spacer, cross spacer, X-spacer, square spacer, rectangle spacer, triangle spacer, diamond spacer, and polygon spacer.

7. A method of assembling a circuit assembly, comprising:
characterizing warpage characteristics of an integrated circuit (IC) with a plurality of connection pads;
determining a location of a ball grid array (BGA) spacer among a plurality of solder balls that are part of a BGA attached to the IC based upon the warpage characteristics of the IC;
determining a shape and dimensions of the BGA spacer based upon a height and spacing of the plurality of solder balls,
wherein the height of the BGA spacer is further based upon a minimum distance between the IC and a PCB to prevent shorting of adjacent solder balls;
producing the BGA spacer;
placing the BGA spacer on the BGA among the plurality of solder balls;
placing BGA and IC on the PCB
wherein the PCB has a plurality of connection pads corresponding to the plurality of solder balls; and
performing solder processing of the IC, BGA, and PCB.

8. The method of claim 7,
wherein determining the location of the BGA spacer includes identifying a location where a distance between the IC and the PCB is less than a minimum distance between the IC and the PCB to prevent shorting of adjacent solder balls.

9. The method of claim 7, further comprising
characterizing warpage characteristics of the PCB,
wherein determining the location of the BGA spacer is further based on the warpage characteristics of the PCB.

10. The method of claim 7, further comprising producing a custom installation template, wherein placing the BGA spacer on the BGA includes using the custom install template.

11. A method of assembling a circuit assembly, comprising:
characterizing warpage characteristics of an integrated circuit (IC) with a plurality of connection pads;
determining locations of a plurality of ball grid array (BGA) spacers among a plurality of solder balls that are part of a BGA attached to the IC based upon the warpage characteristics of the IC;
determining a shape and dimensions of the plurality of BGA spacers based upon a height and spacing of the plurality of solder balls,
wherein a height of the plurality of BGA spacers is further based upon a minimum distance between the IC and a PCB to prevent shorting of adjacent solder balls;
producing the plurality of BGA spacers;
placing the plurality of BGA spacers on the BGA among the plurality of solder balls;
placing the BGA and IC on the PCB
wherein the PCB has a plurality of connection pads corresponding to the plurality of solder balls; and
perform solder processing of the IC, BGA, and PCB.

12. The method of claim 11,
wherein determining the location of the plurality of BGA spacers includes identifying a location where a distance between the IC and the PCB are less than a minimum distance between the IC and the PCB to prevent shorting of adjacent solder balls.

13. The method of claim 11, further comprising
characterizing warpage characteristics of the PCB,
wherein determining the location of the plurality of BGA spacers is further based on the warpage characteristics of the PCB.

14. The method of claim 11, further comprising
producing a custom installation template,
wherein placing the plurality of BGA spacers on the BGA includes using the custom installation template.
